# DEMANDE DE BREVET EUROPEEN

(11) **EP 3 412 625 A1**
(43) Date de publication de la demande: **12.12.2018**
(21) Numéro de dépôt: 17174415.4
(22) Date de dépôt: 05.06.2017
(51) Int. Cl.: B81C 99/00

(54) **PROCEDE DE FABRICATION D'UNE PIECE MICROMECANIQUE**

(71) Demandeur: Nivarox-FAR S.A., 2400 Le Locle (CH)
(72) Inventeur: Cretenet, Davy, 25650 La Chaux-de-Gilley (FR)
(74) Mandataire: ICB SA

(57) **Abrégé**

L'invention se rapporte à un procédé de fabrication d'une pièce mécanique (51) comportant les étapes suivantes :
- se munir (3) d'un substrat (53) en un matériau micro-usinable ;
- graver (5) par photolithographie, dans la totalité de l'épaisseur dudit substrat, un motif (50) comportant ladite pièce avec au moins un pont de matière (57) ;
caractérisé en ce qu'il comporte en outre les étapes suivantes :
- réaliser (13) une fragilisation à coeur du pont de matière (91) afin de former une amorce de rupture (91) le long d'une ligne de rupture (L) du pont de matière (57) ;
- libérer (11) la pièce (51) du substrat (53) afin de la monter dans un dispositif.

## Description

### Domaine de l'invention

L'invention se rapporte à un procédé de fabrication d'une pièce mécanique réalisée à base d'un matériau micro-usinable et, plus particulièrement, une telle pièce destinée à être utilisée pour la fabrication d'une pièce d'horlogerie.

### Arrière-plan de l'invention

Il est connu de fabriquer une partie d'une pièce d'horlogerie en matériau à base de silicium cristallin. En effet, l'utilisation d'un matériau micro-usinable comme le silicium cristallin présente des avantages en terme de précision de fabrication grâce aux avancées des procédés actuels notamment dans le domaine de l'électronique.

Une difficulté à surmonter est toutefois de libérer le composant, sans l'endommager. Généralement, des ponts de matière, sont prévus entre le composant horloger et le reste de la plaque. Ces ponts de matière ont pour rôle de maintenir la pièce solidaire de la plaque pendant toute la fabrication du composant, notamment pendant des traitements appliqués au composant après la gravure (traitement thermique, dépôt d'un revêtement, etc.), tout en facilitant la libération du composant en fin de fabrication.

Le document EP2145857 décrit un tel procédé de fabrication d'un composant horloger. Des ponts de matière sont gravés et maintiennent le composant solidaire de la plaque pendant les différentes étapes de fabrication du composant horloger. Afin de faciliter la libération du composant en fin de fabrication, les ponts de matière comportent une section rétrécie à l'extrémité reliée au composant. Cela permet de créer une zone de faiblesse facilitant la rupture des ponts de matière. En fin de fabrication, le composant horloger est libéré de la plaque par rupture fragile du matériau au niveau des ponts de matière en réponse à une sollicitation mécanique adaptée. La casse du matériau par rupture fragile entre le pont de matière et le composant est difficilement contrôlable.

On connait également du document WO 2015/092012 un tel procédé qui tente de résoudre le problème de casse difficilement contrôlable en mettant en oeuvre une zone de pré-détachage gravée lors de la formation des composants, le composant pouvant être libéré de la plaque en complétant la gravure de la zone de pré-détachage par le biais d'un laser. Un problème connu de la technologie de découpe laser est que cette dernière émet des particules et/ou poussières de silicium se déposant à la surface des composants.

### Résumé de l'invention

Le but de la présente invention est de pallier tout ou partie les inconvénients cités précédemment en proposant un procédé qui autorise, de manière simple, un dégrappage mécanique fiable tout en s'affranchissant des poussières résultant du traitement laser du pont de matière reliant le composant au substrat. De plus, le procédé permet la fabrication de qualité d'une pièce micromécanique pouvant être appliquée à la plupart des parties mécaniques horlogères.

A cet effet, l'invention se rapporte à un procédé de fabrication d'une pièce mécanique comportant les étapes suivantes :
- se munir d'un substrat en un matériau micro-usinable ;
- graver par photolithographie, dans la totalité de l'épaisseur dudit substrat, un motif comportant ladite pièce avec au moins un pont de matière ;
caractérisé en ce qu'il comporte en outre les étapes suivantes :
- réaliser une fragilisation à coeur du pont de matière afin de former une amorce de rupture le long d'une ligne de rupture L du pont de matière ;
- libérer la pièce du substrat afin de la monter dans un dispositif.

Conformément à d'autres caractéristiques avantageuses de l'invention :
- que ladite amorce de rupture est obtenue par une fragilisation du pont de matière sur toute ou partie de son épaisseur ;
   - ladite amorce de rupture s'étend le long de toute la ligne de rupture ;
   - l'amorce de rupture comprend au moins une rangée d'une première zone modifiée le long de la ligne de rupture, à l'intérieur du substrat ;
   - l'amorce de rupture comprend au moins une rangée d'une deuxième zone modifiée le long de la ligne de rupture, à l'intérieur du substrat ;
   - la première zone modifiée et la deuxième zone modifiée se présentent sous la forme d'une rangée de points le long de la ligne de rupture ;
   - la rangée de la première zone modifiée est à une distance d'au moins 10 µm de la face supérieure du substrat ;
   - la rangée de la deuxième zone modifiée est à une distance d'au moins 50 µm de la face supérieure du substrat ;
   - la rangée de la première zone modifiée et la rangée de la deuxième zone modifiée sont réalisées successivement une par une à partir du côté le plus éloigné de la face supérieure du substrat ;
   - la distance entre chaque point d'une même rangée est de 10 µm ;
   - le matériau micro-usinable étant choisi parmi le groupe comprenant du silicium cristallin, de la silice cristalline et de l'alumine cristalline.

### Description sommaire des dessins

D'autres particularités et avantages ressortiront clairement de la description qui en est faite ci-après, à titre indicatif et nullement limitatif, en référence aux dessins annexés, dans lesquels :
- la figure 1 est une représentation d'un substrat après une étape de photolithographie ;
- la figure 2 est un agrandissement d'une partie de la figure 1 ;
- les figures 3a et 3b illustrent respectivement un spiral et son pont de matière ainsi qu'une vue en coupe du pont de matière le long de la ligne de rupture ;
- la figure 4 est une représentation schématique du procédé conforme à l'invention.

### Description détaillée des modes de réalisation préférés

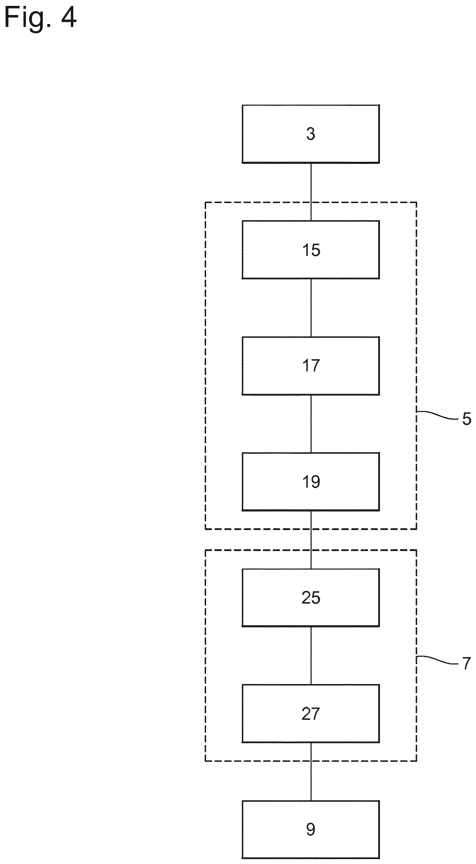

Dans l'exemple illustré à la figure 4, on peut voir le schéma fonctionnel d'un procédé 1. Le procédé comporte principalement quatre étapes 3, 5, 7 et 9 destinées à fabriquer une pièce mécanique 51 dont l'âme est réalisée à base d'un matériau micro-usinable. En effet, un matériau micro-usinable, grâce à ses précisions inférieures au micromètre, est particulièrement utile pour la fabrication d'un élément, par exemple, d'une pièce d'horlogerie et remplace avantageusement un matériau métallique utilisé habituellement.

Dans l'explication ci-après, le matériau micro-usinable peut être à base de silicium cristallin comme, par exemple, du silicium monocristallin, de la silice cristalline comme du quartz ou encore de l'alumine cristalline comme du corindon (également appelé saphir synthétique). Evidemment, d'autres matériaux micro-usinables peuvent être envisagés.

L'étape 3 consiste à se munir d'un substrat 53 en matériau micro-usinable comme, par exemple, une plaquette en silicium monocristallin utilisée pour la fabrication de composants électroniques (également appelé « wafer » en anglais). Préférentiellement, une phase d'amincissement est prévue lors de l'étape 3 afin d'adapter l'épaisseur finale de la pièce 51. Une telle phase peut être réalisée par un procédé de rodage mécanique ou chimique (également connu sous les termes anglais « back lapping »).

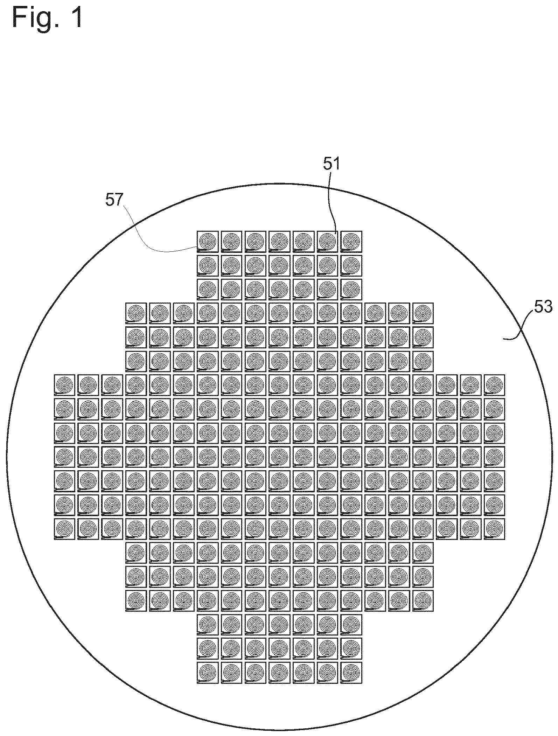

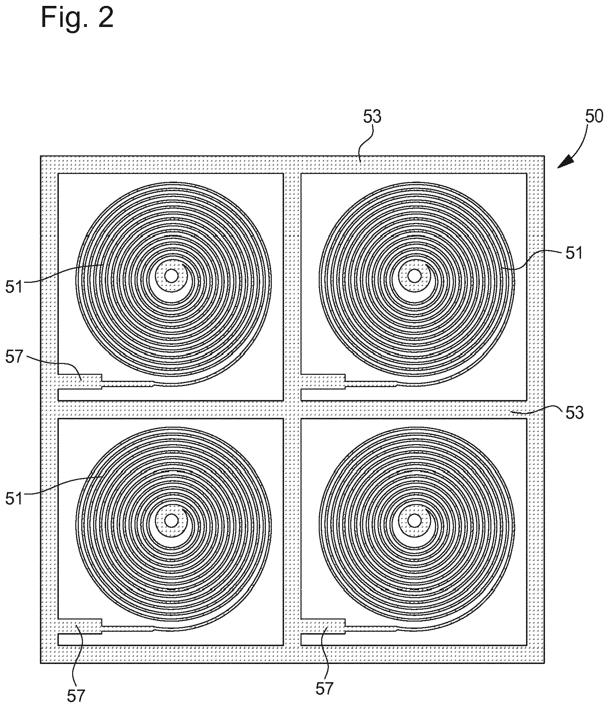

L'étape 5 consiste à réaliser par photolithographie, dans la totalité de l'épaisseur du substrat 53, un motif 50 comportant la pièce mécanique 51 à fabriquer. Avantageusement, comme visible aux figures 1 et 2, la taille, plus grande, du substrat 53 par rapport à celle de la pièce 51 autorise la gravure de plusieurs motifs 50 et donc la fabrication de plusieurs pièces 51 à partir du même substrat 53.

Dans l'exemple illustré aux figures 1 et 2, chaque pièce mécanique 51 est une roue d'échappement pour une pièce d'horlogerie. Bien évidemment, la procédé 1 permet de fabriquer d'autres parties d'une pièce d'horlogerie mais également, comme expliqué ci-après, plusieurs parties différentes sur un même substrat 53.

Une étape optionnelle permet de déposer un revêtement qui remplace avantageusement des qualités tribologiques insuffisantes éventuelles du matériau micro-usinable.

Un tel revêtement peut être, par exemple, à base d'un allotrope de carbone. Il peut ainsi être envisagé de déposer un revêtement de carbone cristallin comme du diamant synthétique par dépôt chimique en phase vapeur (également connu sous l'abréviation anglaise « CVD »). Il peut également être déposé du carbone amorphe comme du carbone sous forme diamant (également connu sous l'abréviation anglaise « DLC » venant des termes « Diamond-Like-Carbon ») par dépôt physique en phase vapeur (également connu sous l'abréviation anglaise « PVD »). Bien entendu, un ou plusieurs autres matériaux peuvent être utilisés en remplaçant ou en adjuvant du carbone. D'autres procédés de dépôt sont également envisageables.

L'étape 7 consiste à réaliser une amorce de rupture 91 sur la pièce 51, au niveau du pont de matière 57, afin que la pièce 51 p soit prête à être dégrappée.

L'étape 9 consiste à libérer chaque pièce 51 du substrat 53. Ainsi, dans l'exemple illustré aux figures, on peut obtenir sur un même substrat 53, selon le procédé 1, plusieurs dizaines de pièces mécaniques 51. Dans l'exemple illustré aux figures 1 à 4, on peut ainsi obtenir, par exemple, des ensembles spiral/virole en silicium monocristallin ou encore des roues d'échappement dont l'âme est en silicium monocristallin.

Le procédé peut comprendre une étape optionnelle de nettoyage, entre l'étape 7 et l'étape 9, dans le cas où le système d'aspiration ne serait pas optimal.

Le procédé 1 comporte les étapes consécutives 3, 5, 7 et 9 comme illustré à la figure 4. La première étape 3 consiste à se munir d'un substrat 53 en matériau micro-usinable.

Puis la deuxième étape 5 consiste à réaliser par photolithographie, dans la totalité de l'épaisseur du substrat 53, les motifs 50 comportant chacun une pièce mécanique 51 à fabriquer. Selon le mode de réalisation illustré dans le schéma fonctionnel de la figure 4, la deuxième étape 5 comporte trois phases 15, 17 et 19.

Dans une première phase 15, un masque de protection est structuré sur le substrat 53. Préférentiellement, le masque de protection est réalisé à l'aide d'une résine photosensible. Le masque de protection est ainsi formé à l'aide d'un rayonnement sélectif permettant de structurer ledit masque de forme correspondante à chaque motif 50 à réaliser. Grâce à cette étape 15, il sera possible de manière très précise de graver n'importe quelle forme plane de manière sélective sur le substrat 53.

Dans une deuxième phase 17, une attaque par gravure anisotropique de l'ensemble substrat 53 - masque de protection est effectuée. Préférentiellement, une attaque du type gravure ionique réactive profonde est utilisée (également connu sous l'abréviation anglaise « DRIE »). L'attaque anisotropique permet de graver se manière sensiblement rectiligne le substrat 53 au niveau des zones non protégées par ledit masque de protection. Préférentiellement, la gravure lors de la deuxième phase 17 est réalisée sur toute l'épaisseur du substrat 53 et, éventuellement, selon un axe cristallographique du matériau micro-usinable favorable à cette attaque.

De plus de manière préférée selon l'invention, chaque motif 50, comme illustré aux figures 1 et 2, comporte au moins un pont de matière 57. Ce dernier autorise le maintien de la pièce 51 par rapport au substrat 53 jusqu'à l'étape 27. Comme visible à la figure 2, le pont de matière 57 comporte une section constante.

Dans une troisième et dernière phase 19 de la deuxième étape 5, le masque de protection est retiré de la surface du substrat 53. On obtient alors un substrat 53 comportant plusieurs motifs 50 comprenant une pièce 51 solidaire du substrat 53 par au moins un pont de matière 57 comme illustré aux figures 1 et 2. Bien entendu, lors de l'étape 5, il peut être envisagé de réaliser un seul ou plus de deux ponts de matière 57.

La troisième étape 7 consiste à former une amorce de rupture 91 sur le pont de matière 57 à l'aide d'un laser en réalisant une fragilisation à coeur (ou stealth dicing en anglais) afin que la pièce 51 soit prête à être dégrappée sans avoir à toucher la partie en matériau micro-usinable.

Selon l'invention, l'amorce de rupture 91 comprend au moins une rangée d'une première zone modifiée 41 le long de la ligne de rupture L, à l'intérieur du substrat.

De manière avantageuse, l'amorce de rupture 91 comprend au moins une rangée d'une deuxième zone modifiée 42 le long de la ligne de rupture L, à l'intérieur du substrat également.

L'amorce de rupture 91 peut comprendre une rangée d'une troisième zone modifiée, voire plus si nécessaire.

Bien évidemment, l'amorce de rupture 91 peut comprendre une pluralité de rangées d'une première zone modifiée 41 et une pluralité de rangées d'une deuxième zone modifiée 42.

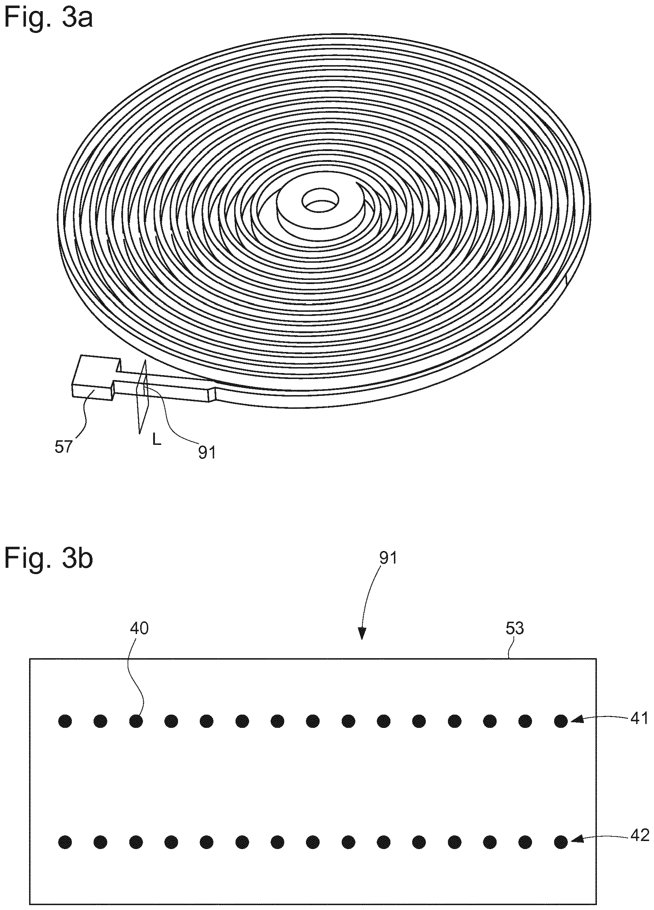

Comme on peut l'observer sur la figure 3, la première zone modifiée 41 et la deuxième zone modifiée 42 se présentent sous la forme d'une rangée de points 40 disposés le long de la ligne de rupture L, ces points 40 étant le résultat de la fusion de la matière au moyen d'un laser à impulsion tel qu'un laser infrarouge par exemple.

Selon l'invention, la rangée de la première zone modifiée 41 est à une distance d'au moins 10 µm de la face supérieure du substrat 53, et la rangée de la deuxième zone modifiée 42 est à une distance d'au moins 50 µm de la face supérieure du substrat 53. Bien évidemment, la distance de chaque rangée peut être adaptée par l'homme du métier en fonction de l'épaisseur totale de la pièce et du profil géométrique du pont de matière 57.

Lors de la réalisation de l'amorce de rupture 91, la rangée de la première zone modifiée 41 et la rangée de la deuxième zone modifiée 42 sont réalisées successivement une par une à partir du côté le plus éloigné de la face supérieure du substrat 53, la rangée de la première zone modifiée 41 et la rangée de la deuxième zone modifiée 42 étant superposées l'une au-dessus de l'autre.

La distance entre chaque point 40 d'une même rangée est de 10 µm, les points 40 d'une même rangée étant équidistants les uns des autres de sorte que la rupture du pont de matière 57 soit propre.

Bien entendu, l'homme du métier pourra adapter la configuration de l'amorce de rupture, c'est-à-dire adapter le nombre de zones, la distance de chaque rangée, et la distance entre chaque point d'une même rangée, en fonction de l'épaisseur de la pièce et du profil géométrique du pont de matière

A la fin de l'étape 7, on obtient donc un substrat 53 dont la pièce 51 de chaque motif 50 est prête à être dégrappée. Avantageusement selon l'invention, les dizaines de pièces 51 sont donc toujours manipulables ensemble et peuvent être fournies avec ou sans le substrat 53.

La quatrième et dernière étape 9 consiste à appliquer une contrainte sur les ponts de matière 57, au niveau de l'amorce de rupture 91 formée lors de l'étape 7, afin qu'ils cèdent dans le but de récupérer ladite pièce. Avantageusement selon l'invention, ce déplacement peut être réalisé en tirant directement sur le pont de matière 57 ce qui permet le montage final de chaque pièce 51 sans aucune manipulation directe sur le matériau micro-usinable. L'étape 9 peut ainsi être réalisée manuellement à l'aide de brucelles ou à l'aide d'un automate.

Dans l'exemple illustré aux figures 1 et 2, la pièce 51 est une roue d'échappement. Cependant l'invention ne saurait s'y limiter et, à titre d'exemple, la pièce 51 pourrait être un autre type de rouage, une couronne ou même un ensemble spiral - virole.

## Revendications

1. Procédé de fabrication (1) d'une pièce mécanique (51) comportant les étapes suivantes :
- se munir (3) d'un substrat (53) en un matériau micro-usinable ;
- graver (5) par photolithographie, dans la totalité de l'épaisseur dudit substrat, un motif (50) comportant ladite pièce avec au moins un pont de matière (57) ;
**caractérisé en ce qu'**il comporte en outre les étapes suivantes :
- réaliser (13) une fragilisation à coeur dudit pont de matière (91) afin de former une amorce de rupture (91) le long d'une ligne de rupture (L) du pont de matière (57) ;
- libérer (11) la pièce (51) du substrat (53) afin de la monter dans un dispositif.

2. Procédé selon la revendication 1, **caractérisé en ce que** ladite amorce de rupture (91) est obtenue par une fragilisation du pont de matière (57) sur toute ou partie de son épaisseur.

3. Procédé selon la revendication 1 ou 2, **caractérisé en ce que** ladite amorce de rupture (91) s'étend le long de toute la ligne de rupture (L).

4. Procédé selon l'une des revendications 1 à 3, **caractérisé en ce que** l'amorce de rupture (91) comprend au moins une rangée d'une première zone modifiée (41) le long de la ligne de rupture (L), à l'intérieur du substrat.

5. Procédé selon l'une des revendications 1 à 4, **caractérisé en ce que** l'amorce de rupture (91) comprend au moins une rangée d'une deuxième zone modifiée (42) le long de la ligne de rupture (L), à l'intérieur du substrat.

6. Procédé selon les revendications 4 et 5, **caractérisé en ce que** la rangée de la première zone modifiée (41) et la rangée de la deuxième zone modifiée (42) se présentent sous la forme d'une rangée de points (40) le long de la ligne de rupture (L).

7. Procédé selon les revendications 4 et 6, **caractérisé en ce que** la rangée de la première zone modifiée (41) est à une distance d'au moins 10 µm de la face supérieure du substrat.

8. Procédé selon les revendications 5 et 6, **caractérisé en ce que** la rangée de la deuxième zone modifiée (42) est à une distance d'au moins 50 µm de la face supérieure du substrat.

9. Procédé selon l'une des revendications 4 à 8, **caractérisé en ce que** la rangée de la première zone modifiée (41) et la rangée de la deuxième zone modifiée (42) sont réalisées successivement une par une à partir du côté le plus éloigné de la face supérieure du substrat.

10. Procédé selon la revendication 6, **caractérisé en ce que** la distance entre chaque point (40) d'une même rangée est de 10 µm.

11. Procédé selon l'une des revendications précédentes, **caractérisé en ce que** ledit matériau micro-usinable étant choisi parmi le groupe comprenant du silicium cristallin, de la silice cristalline et de l'alumine cristalline.
